# EUROPEAN PATENT APPLICATION

(11) **EP 4 282 569 A1**
(43) Date of publication of application: **29.11.2023**
(21) Application number: 22203348.2
(22) Date of filing: 24.10.2022
(51) Int. Cl.: B23K 1/00, B23K 1/005, B23K 3/06, B23K 3/08, B23K 37/04, B23K 37/047, B23K 26/20, G01R 1/073, G01R 3/00, H01L 21/48, H01L 21/67, H05K 3/34

(54) **TURNTABLE TYPE PROBE PIN BONDING APPARATUS WITH A DUAL LASER OPTIC MODULE**

(30) Priority: 24.05.2022 KR 20220063643
(71) Applicant: Laserssel Co., Ltd, Asan-si, Chungcheongnam-do 31499 (KR)
(72) Inventor: CHOI, Jae Joon, 12771 Gwangju-si, Gyeonggi-do (KR); KIM, Byung Roc, 21974 Incheon (KR); KIM, Tae Kyu, 18601 Hwaseong-si, Gyeonggi-do (KR); KIM, Dong Sik, 10374 Goyang-si, Gyeonggi-do (KR); LEE, Jun Gi, 31155 Cheonan-si, Chungcheongnam-do (KR); LEE, Sang Won, 31463 Asan-si, Chungcheongnam-do (KR)
(74) Representative: López Camba, Emilia

(57) **Abstract**

To achieve the above purpose, a dual laser optic module of a turntable-type probe pin laser bonding apparatus of the present invention comprising: a pickup unit that rotates 360 degrees on the horizontal line and transfers the probe pin placed on the tray after holding it with a pin gripper consisting of a pair of clamps; a dipping unit applies solder paste to the probe pin transferred by the pickup unit; and a laser bonding unit bonds the probe pins to the probe card by irradiating a laser beam respectively onto the solder paste of the probe pins transferred from the dipping unit by the pickup unit, wherein a body unit of a circular or polygonal shape with an empty interior; a first laser connection unit connected in a first direction toward the inside of the body part to which a first laser beam of a specific wavelength band is incident; a second laser connection unit connected in a second direction orthogonal to the first direction toward the inside of the body part to receive a second laser beam of a specific wavelength band; a laser filter unit equipped inside the body part and overlapping the first laser beam and the second laser beam that meet inside the body part to have a co-focus by being transmitted or reflected, respectively; and an overlapping laser emitting unit emitting the overlapped laser beam in a third direction of the body part to have a co-focus by the laser filter part.

## Description

### TECHNICAL FIELD

The present invention relates to a turntable-type probe pin laser bonding apparatus. More particularly, a dual laser optic module of the turntable-type probe pin bonding apparatus of the present invention provides an integrated dual laser optic module that is overlappingly irradiated on a co-focus by improving the conventional first and second laser optic modules that have been completely separated and arranged independently with different focal points. During laser bonding of probe pins, which are getting miniaturized day by day, the power and density of the first and second laser beams overlappingly irradiated from the integrated dual laser optic module can be precisely controlled so that a turntable-type probe pin laser bonding apparatus of the present invention can significantly improve the bonding defect rate, as well as contribute to high integration and high precision of the apparatus.

### BACKGROUND ART

In general, a probe card is an apparatus for testing the electrical performance of a chip formed on a semiconductor substrate.

More specifically, an innumerable plurality of probe pins is bonded to the probe card. The plurality of probe pins contacts the semiconductor chip pad and applies an electrical signal to check whether the chip is normal.

As these semiconductor devices continue to be highly integrated, the circuit patterns of the semiconductor devices are also being miniaturized. Accordingly, there is also a demand for a probe card to which probe pins are bonded to have an interval corresponding to the interval of the microcircuit patterns of the semiconductor device.

However, since the conventional method of manufacturing a probe card is not fully automated, it takes a lot of time to manufacture one probe card, and the defect rate is also high.

More specifically, in the past, a person used a pincette to move and load probe pins on a wafer into a cassette. Since a person had to manually set the probe pin on the wafer vertically and then load it into the cassette, there was a problem in that the probe pin was scratched or bent, resulting in a defect.

In recent years, since the thickness of the probe pins is becoming finer to reduce the gap between the probe pins, the restoring force of the probe pins has been greatly reduced. That is, probe pins on the wafer are more likely to be easily damaged, even with a small impact in the process of being manually transferred to the cassette. Therefore, it is necessary to automate the transfer of the probe pin through a minimum force that does not damage the probe pin.

In addition, conventionally, when a person directly transfers a probe pin, the time for loading the probe pin on the wafer into the cassette is different depending on the technical skill level of each person. Even for a skilled person, it was difficult to accurately predict the production volume of semi-finished products over time because there was a difference in production per hour.

And conventionally, due to the thickness of the apparatus for transferring the probe pins, there was a limit in narrowing the gap between the probe pins attached to the probe card.

More specifically, since the grip module that grips and transports the probe pins on the probe card has a certain thickness, even though the thickness of the probe pins is made thin, there was a limit that the gap between the probe pins attached to the probe card could not be narrowed down to at least the thickness of the grip module.

Accordingly, at a probe card production site, there is a high demand for a probe pin bonding apparatus that can operate fully automatically, minimize the impact applied to the probe pin, and minimize the gap between the probe pins attached to the probe card.

Hereinafter, referring to FIGS. 1 and 2, the applicant of the present invention has previously filed a patent application for a turntable-type probe pin laser bonding apparatus that automatically laser bonds the probe pins to the probe card while the pin grippers mounted on each of the four sides, rotate continuously in a turntable method.

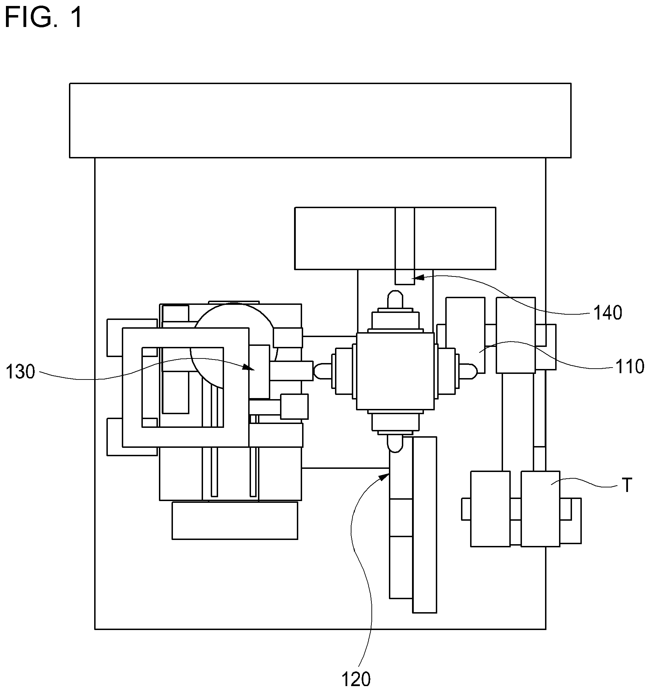

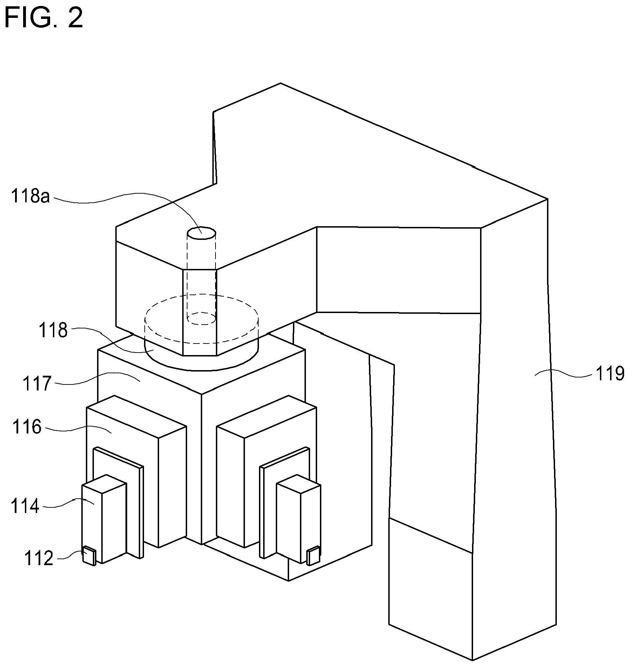

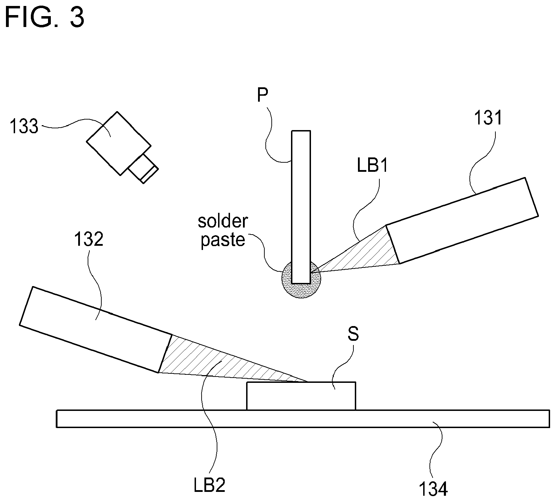

FIG. 1 is a plan view showing the configuration of a conventional turntable-type probe pin laser bonding apparatus according to some embodiments and FIG. 2 is a perspective view separately showing the pickup unit of FIG. 1. FIG. 3 is an exemplary view schematically showing a laser bonding process of a conventional turntable-type probe pin laser bonding apparatus.

Referring to FIG. 1, a conventional turntable-type probe pin laser bonding apparatus (100) may include a pickup unit (110), a dipping unit (120), a laser bonding unit (130), and a suction unit (140).

First, the pickup unit (110) is located in the center of the units (120, 130, 140) and transfers the probe pin (P) placed on the tray (T) while rotating 360 degrees on the horizontal line.

As shown in FIG. 1, the pickup unit (110) picks up the probe pin (P) from the tray (T) disposed on the right side of the pickup unit (110) (based on FIG. 1) and then rotates in a clockwise direction with a time difference of 90 degrees.

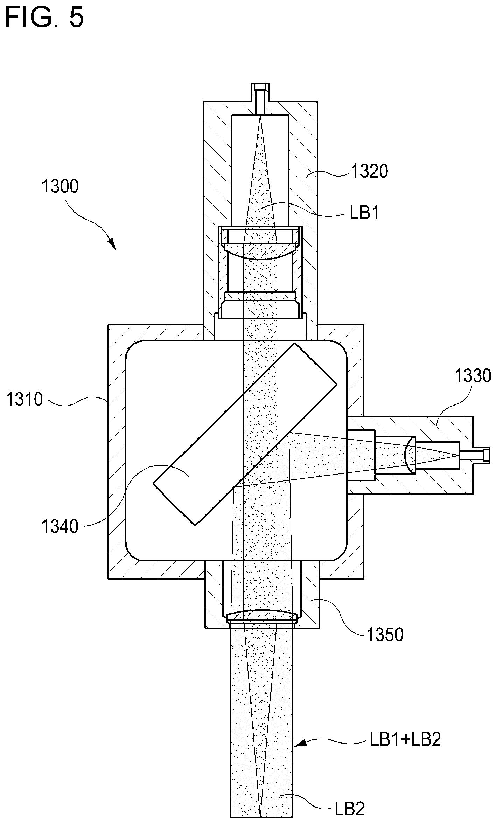

In addition, the dipping unit (120) is located on the lower side of the pickup unit (110) (based on FIG. 1). The dipping unit (120) applies solder paste (refer to FIG. 5) to the probe pin (P) transferred by rotating 90 degrees clockwise by the pickup unit (110).

In addition, the laser bonding unit (130) is located on the left side of the pickup unit (110) (based on FIG. 1). The laser bonding unit (130) bonds the probe pin (P) to the probe card (S) by irradiating a laser beam to the solder paste of the probe pin (P) rotated 90 degrees clockwise from the dipping unit (120) by the pickup unit (110) and transferred.

In addition, the suction unit (140) is located above the pickup unit (110) (based on FIG. 1). The suction unit (140) removes by suction the defective probe pin (P) when a defect occurs among the probe pins (P) rotated 90 degrees clockwise from the laser bonding unit (130) by the pickup unit (110) and transferred.

That is, the pickup unit (110) picks and fixes the probe pin (P) from the tray (T) while rotating clockwise with a time difference by a set angle (e.g., 90 degrees). And then, the dipping process by the dipping unit (120), the laser bonding process by the laser bonding unit (130), and the suction process by the suction unit (140) are sequentially performed.

Hereinafter, by referring to FIG. 2, the configuration of the pickup unit will be described in detail as follows.

A pin gripper (112) in the shape of clamps for gripping and fixing the probe pin (P) is provided at the lowest end of the pickup unit (110).

In addition, a force control unit (114) for controlling the pin gripper (112) is provided at the upper end of the pin gripper (112) so that a constant grip force is applied to the probe pin (P).

In addition, while the pin gripper (112) and the force control unit (114) are mounted on the Z-axis driving unit (116), the pin gripper (112) and the force control unit (114) are also raised and lowered together by the vertical driving of the Z-axis driving unit (116).

In addition, the Z-axis driving unit (116) is provided on each side of the body unit (117) in the shape of a square box, and the body unit (117) has four side surfaces perpendicular to each other.

Accordingly, the pin gripper (112), the force control unit (114), and the Z-axis driving unit (116) are provided on each side of the body unit (117), respectively.

In addition, a rotation driving unit (118) is integrally coupled to the upper end of the body unit (117). The body unit (117) is rotated by, for example, 90 degrees by the rotational force of the rotation drive unit (118).

When the body unit (117) rotates, the pin gripper (112), the force control unit (114), and the Z-axis driving unit (116), which are fixedly coupled to each side of the body unit (117), are also rotated together with the body unit (117).

In addition, as the support frame (119) in the form of a gantry is coupled to the upper rotation shaft (118a) of the rotation drive unit (118), the pickup unit (110) comprising the rotation driving unit (118) is supported by the support frame (119) to be rotatable.

Therefore, the pickup unit (110) may pick up the provided probe pin (P) while being placed on the tray (T) and transfer it clockwise by a preset angle on the horizontal line.

In addition, referring to FIG. 3, in the laser bonding unit (130), a first laser optic module (131) that irradiates a first laser beam (LB1) to the solder paste applied to the probe pin (P) and a second laser optic module (132) for irradiating a second laser beam (LB2) on the upper surface of the probe card (S) to which the probe pin (P) are respectively divided and configured.

Accordingly, the first laser optic module (131) irradiates the first laser beam (LB1) to the solder paste applied to the lower end of the probe pin (P) to heat the solder paste to the melting point. At the same time, the second laser optic module (132) irradiates the second laser beam (LB2) on the upper surface of the probe card (S), to which the probe pin (P) is to be bonded to preheat the upper surface of the probe card (S) to below the melting point of the solder paste.

Therefore, when the solder paste is melted by the first laser beam (LB1) irradiated from the first laser optic module (131), the pin gripper (112) descends to bond the probe pin (P) to the upper surface of the probe card (S).

However, as described above, in the dual laser optic module of the conventional probe pin laser bonding apparatus, the first and second laser optic modules, each having a different focus, are configured separately, and the laser beam is separately and overlappingly irradiated while being mounted at different positions. Therefore, it was not easy to precisely control the power and density of the first and second laser beams irradiated from the first and second laser optic modules to form a target temperature required for laser bonding on the substrate. Due to this, there was a problem in that the defect rate was increased in the laser bonding process of the probe pins, which are being miniaturized day by day.

In addition, in designing and manufacturing equipment by applying two separate optical systems, i.e., the first and second laser optic modules, there are many spatial restrictions in the arrangement or interaction of the conventionally separated laser optic module and other components. Therefore, improvement tasks remained for high-density and precision equipment.

### PRIOR ARTS

1. Korean Patent No. 1748583 (Registration Date: June 16, 2017)
2. Korean Patent No. 1879376 (Registration Date: July 11, 2018)
3. Korean Patent Application No. 2021-0116290 (Publication Date: September 27, 2021)

### DISCLOSURE OF INVENTION

### PROBLEM TO BE SOLVED BY THE INVENTION

The present invention was invented to solve the problems described above. The dual laser optic module of the turntable-type probe pin bonding apparatus of the present invention is to provide an integrated dual laser optic module that is overlappingly irradiated on a co-focus by improving the conventional first and second laser optic modules that have been completely separated and arranged independently with different focal points. During laser bonding of probe pins, which are getting miniaturized day by day, the power and density of the first and second laser beams overlappingly irradiated from the integrated dual laser optic module can be precisely controlled so that a turntable-type probe pin laser bonding apparatus of the present invention can significantly improve the bonding defect rate, as well as contribute to high integration and high precision of the apparatus.

### MEANS FOR SOLVING THE PROBLEM

To achieve the above purpose, according to some embodiments of the present invention, a dual laser optic module of a turntable-type probe pin laser bonding apparatus comprising: a pickup unit that rotates 360 degrees on the horizontal line and transfers the probe pin placed on the tray after holding it with a pin gripper consisting of a pair of clamps; a dipping unit applies solder paste to the probe pin transferred by the pickup unit; and a laser bonding unit bonds the probe pins to the probe card by irradiating a laser beam respectively onto the solder paste of the probe pins transferred from the dipping unit by the pickup unit, wherein a body unit of a circular or polygonal shape with an empty interior; a first laser connection unit connected in a first direction toward the inside of the body part to which a first laser beam of a specific wavelength band is incident; a second laser connection unit connected in a second direction orthogonal to the first direction toward the inside of the body part to receive a second laser beam of a specific wavelength band; a laser filter unit equipped inside the body part and overlapping the first laser beam and the second laser beam that meet inside the body part to have a co-focus by being transmitted or reflected, respectively; and an overlapping laser emitting unit emitting the overlapped laser beam in a third direction of the body part to have a co-focus by the laser filter part.

In addition, according to some embodiments, the first and second laser connection units are vertically or horizontally divided around the body unit so that the first and second laser beams having different wavelength bands are vertically incident into the body unit.

Also, according to some embodiments, the laser filter unit is installed to be inclined toward the first and second laser connection units inside the body unit.

In addition, according to some embodiments, the first and second laser connection units each have a collimation lens therein, and any one of the first and second laser connection units is further equipped with a diffractive optical element (DOE) lens therein.

In addition, according to some embodiments, the overlapping laser emitting unit is equipped with a focusing lens therein.

In addition, according to some embodiments, the first and second laser beams emitted from the overlapping laser emitting unit have different wavelengths and areas.

In addition, according to some embodiments, the wavelengths of the first and second laser beams are 980nm and 808nm, respectively.

### EFFECT OF THE INVENTION

As described above, by providing an integrated dual laser optic module that is overlappingly irradiated on a co-focus, during laser bonding of probe pins that are getting miniaturized day by day, the present invention can precisely control the power and density of the first and second laser beams overlappingly irradiated from the integrated dual laser optic module. Accordingly, there is an effect that the bonding defect rate is remarkably improved.

In addition, the present invention integrates two optical systems separated by conventional first and second laser optic modules into one dual laser optic module. Therefore, there is an effect that can contribute to high integration and precision of the apparatus because many space restrictions are eliminated in disposing or interacting with the laser optic module and other components, even in designing and manufacturing equipment.

### BRIEF DESCRIPTION OF DRAWINGS

FIG. 1 is a plan view showing the configuration of a conventional turntable-type probe pin laser bonding apparatus according to some embodiments.
FIG. 2 is a perspective view showing the pickup unit of FIG. 1 separated.
FIG. 3 is an exemplary view schematically illustrating a laser bonding process of a conventional turntable-type probe pin laser bonding apparatus.
FIG. 4 is an full front view of the dual laser optic module of the turntable-type probe pin laser bonding apparatus of the present invention according to some embodiments.
FIG. 5 is a state diagram in which a dual laser beam is emitted in FIG. 4.
FIG. 6 is an actual image in which the dual laser beam of FIG. 5 is overlappingly irradiated on a plane.
FIG. 7 is a transmittance (T) graph of the laser filter unit according to the present invention.

### MODE(S) FOR CARRYING OUT THE INVENTION

The terminology herein describes particular embodiments only and is not intended to be limiting. As used herein, the singular forms "a," "an," and "the" are intended to include the plural forms, including "at least one," unless the content clearly indicates otherwise. It will be further understood that the terms "comprises," "comprising," "includes," and/or "including," when used in this specification, specify the presence of stated features, integers, steps, operations, elements, and/or components, but do not preclude the presence or addition of one or more other features, integers, steps, operations, elements, components, and/or groups thereof.

Unless otherwise defined in this specification, all terms used herein (including technical and scientific terms) have the same meaning as commonly understood by those skilled in the art.

It will be further understood that terms, such as those defined in commonly used dictionaries, should be interpreted as having a meaning that is consistent with their meaning in the context of the relevant art and will not be interpreted in an ideal or excessively formal sense unless clearly defined in the present specification.

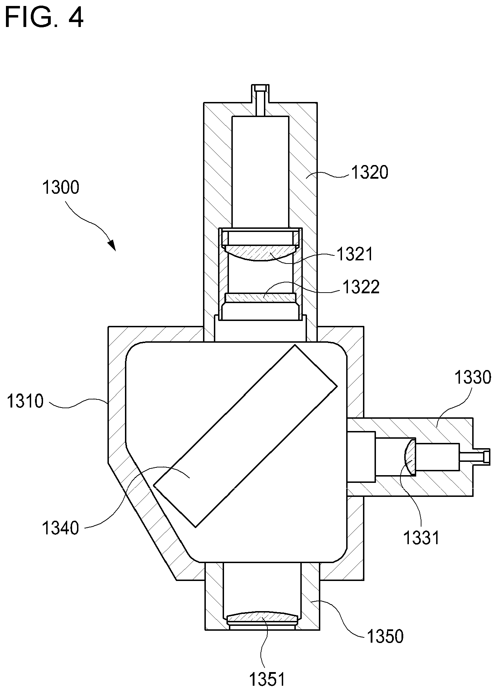

Hereinafter, the co-focal dual laser optic module of the turntable-type probe pin laser bonding apparatus, according to some embodiments of the present invention, will be described in detail with reference to the accompanying FIGS. 4 to 7 as follows.

As described above with reference to FIGS. 1 and 3, a turntable-type probe pin laser bonding apparatus of the present invention comprising: a pickup unit (110) that rotates 360 degrees on the horizontal line and transfers the probe pin placed on the tray after holding it with a pin gripper (112) consisting of a pair of clamps; a dipping unit (120) applies solder paste to the probe pin transferred by the pickup unit (110); and a laser bonding unit (130) bonds the probe pins to the probe card by irradiating two laser beams respectively onto the solder paste of the probe pins transferred from the dipping unit (120) by the pickup unit (110).

In particular, the present invention relates to a dual laser optic module (1300) for forming co-focus overlapping laser beams (LB1+LB2) included in the laser bonding unit (130).

Without having two laser optic modules (131, 132, refer to FIG. 3), respectively, as conventionally, the dual laser optic module (1300) includes a co-focus dual laser optic module (1300) integrated into one body unit (1310) so that the first and second laser connection units (1320)(1330) have a co-focus.

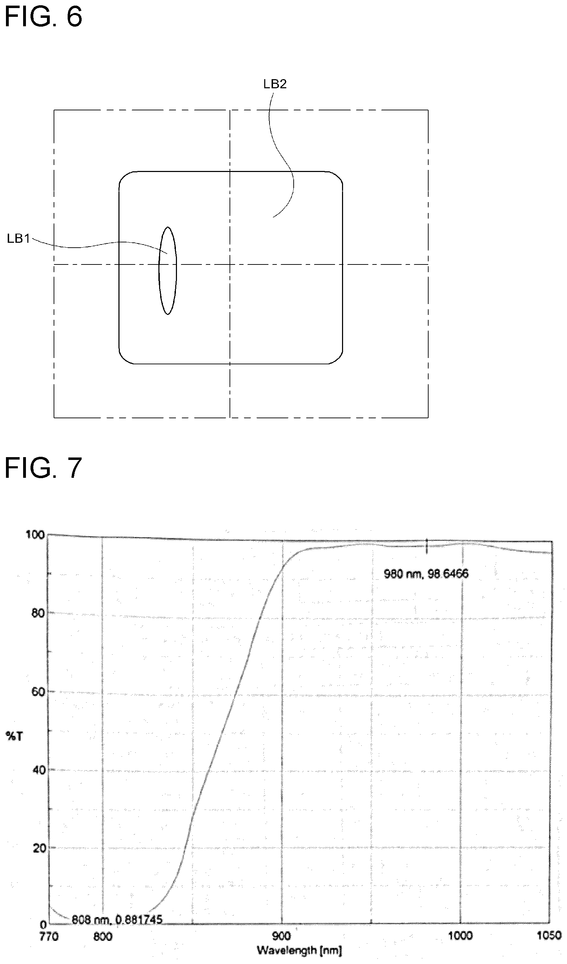

FIG. 4 is an full front view showing the dual laser optic module of the turntable-type probe pin laser bonding apparatus of the present invention according to some embodiments; FIG. 5 is a state diagram in which a dual laser beam is emitted in FIG. 4; FIG. 6 is an actual image in which the dual laser beam of FIG. 5 is overlappingly irradiated on a plane; and FIG. 7 is a transmittance (T) graph of the laser filter unit according to the present invention.

Referring to the figures, the dual laser optic module (1300) for forming a co-focus overlapping laser beam is equipped with the body unit (1310) having a circular or polygonal shape with an empty interior, according to an exemplary embodiment of the present invention.

In addition, it is equipped with the first laser connection unit (1320) connected in a first direction toward the inside of the body unit (1310) to which the first laser beam (LB1) of a specific wavelength band is incident.

In addition, it is equipped with the second laser connection unit (1330) connected in a second direction (e.g., horizontal direction) orthogonal to the first direction (e.g., vertical direction) toward the inside of the body unit (1310) to which the second laser beam (LB2) of a specific wavelength band is incident (refer to FIG. 5).

According to an exemplary embodiment, the first and second laser connection units (1320, 1330) allow the first and second laser beams (LB1, LB2) having different wavelength bands to be perpendicular to each other in the body unit (1310). In order to be incident perpendicularly to each other, the body portion (1310) is divided and connected in a vertical or horizontal direction.

In addition, the first and second laser connection units (1320, 1330) are equipped with collimation lenses (1321, 1331) therein, respectively. Any one of the first and second laser connection units (1320, 1330) is further equipped with a diffractive optical element (DOE) lens (1322) therein.

Here, the collimation lenses (1321, 1331) convert the incident laser beams (LB1, LB2) into parallel light, and the diffractive optical element lens (1322) performs a function of uniformly distributing the energy of the planar laser beam.

In addition, the inside of the body unit (1310) is equipped with the laser filter unit (1340) that overlaps the two laser beams (LB1, LB2) to have a co-focus as the first laser beam LB1 and the second laser beam LB2 that meet inside the body unit 1310 are transmitted or reflected, respectively.

That is, two laser beams (LB1, LB2) of different wavelengths are vertically incident in the laser filter unit (1340) through a first laser connection unit (1320) and a second laser connection unit (1330) that are vertically or horizontally coupled to the body unit (1310). Then, a single overlapping laser beam (LB1+LB2) is formed by being transmitted or reflected by the laser filter unit (1340).

More specifically, the laser filter unit (1340) overlaps each other by matching the optical paths of the two laser beams (LB1, LB2), and the one overlapping laser beam (LB1+LB2) is emitted downward through the focusing lens (1351) of the overlapping laser emitting unit (1350). (Refer to FIG. 5).

For this, the laser filter unit (1340) is installed in the body unit (1310) to be inclined toward the first and second laser connection units (1320, 1330).

In addition, it is equipped with an overlapping laser emitting unit for emitting the overlapped laser beams (LB1+JB2) to have a co-focus by the laser filter unit (1340) in a third direction (e.g., downward) of the body unit (1310). (Refer to FIG. 5).

In this case, a single focusing lens (1351) is equipped inside the overlapping laser emitting unit (1350).

Referring to FIG. 6, the first and second laser beams emitted from the overlapping laser emitting unit (1350) have different wavelengths and areas.

For example, the first laser beam (LB1) may be linear, and the second laser beam may be a laser beam (LB2) having a larger area and a square shape, including the linear first laser beam (LB1).

The overlapping laser beams (LB1+LB2) having different wavelengths, i.e., having the same focus as above, emitted in the same path is, for example, to be irradiated in a form in which the first laser beam (LB1) having a size of 0.2 mm × 0.9 mm (LB1) is overlapped inside the second laser beam (LB2) having a size of 2 mm × 2 mm. In this case, the wavelengths of the overlapping first and second laser beams (LB1+LB2) may be 980nm and 808nm, respectively, and in the overlapping state, the wavelengths are maintained the same.

In addition, in the region where the first and second laser beams (LB1, LB2) are irradiated overlappingly, the first or second laser beams (LB1, LB2) form a higher temperature than the region irradiated alone. Accordingly, the substrate is heated to a higher temperature in the region where the two laser beams (LB1, LB2) overlap and irradiate.

Referring to FIG. 7, according to an embodiment, when the wavelengths of the first and second laser beams (LB1, LB2) are respectively formed at 980nm and 808nm, the first laser beam (LB1), having a wavelength of 980nm passes through the laser filter unit (1340) by the laser filter unit (1340) and the second laser beam (LB2) having a wavelength of 808nm is reflected by the laser filter unit (1340). And the overlapped laser beams (LB1+LB2) having co-focus are emitted downward.

That is, the overlapping dual laser beams (LB1+LB2), as described above, are emitted on the lower substrate (not shown) through the focusing lens (1351) of the overlapping laser emitting unit (1350).

Accordingly, as described above, the present invention provides an integrated dual laser optic module (1300) that is irradiated on the co-focus so that during laser bonding of a probe pin, which is being miniaturized day by day, it is possible to precisely control the power and density of the first and second laser beams (LB1, LB2) overlappingly irradiated from the integrated dual laser optic module (1300), respectively.

In addition, the present invention integrates two optical systems separated by conventional first and second laser optic modules into one dual laser optic module. Therefore, there is an effect that can contribute to high integration and precision of the apparatus because many space restrictions are eliminated in disposing or interacting with the laser optic module and other components, even in designing and manufacturing equipment.

Therefore, the present invention is not limited only by the embodiments described above. It is possible to create the same effect even if the apparatus's detailed configuration or number and layout structure are changed, or the detailed steps are changed and added. It is possible to add, delete, and modify various configurations within the scope of the technical spirit of the present invention by those of ordinary skill in the art.

### DESCRIPTION OF THE NUMERALS

1300: dual laser optic module
1310: body unit
1320: first laser connection unit
1321, 1331: collimation lenses
1322: diffractive optical element (DOE) lens
1330: second laser connection unit
1340: laser filter unit
1350: overlapping laser emitting unit
1351: focusing lens
LB1, LB2: first laser beam, second laser beam
LB1+LB2: co-focus overlapping laser beams

## Claims

1. A dual laser optic module of a turntable-type probe pin laser bonding apparatus comprising:
a pickup unit that rotates 360 degrees on the horizontal line and transfers the probe pin placed on the tray after holding it with a pin gripper consisting of a pair of clamps;
a dipping unit applies solder paste to the probe pin transferred by the pickup unit; and
a laser bonding unit bonds the probe pins to the probe card by irradiating a laser beam respectively onto the solder paste of the probe pins transferred from the dipping unit by the pickup unit, wherein
a body unit of a circular or polygonal shape with an empty interior;
a first laser connection unit connected in a first direction toward the inside of the body part to which a first laser beam of a specific wavelength band is incident;
a second laser connection unit connected in a second direction orthogonal to the first direction toward the inside of the body part to receive a second laser beam of a specific wavelength band;
a laser filter unit equipped inside the body part and overlapping the first laser beam and the second laser beam that meet inside the body part to have a co-focus by being transmitted or reflected, respectively; and
an overlapping laser emitting unit emitting the overlapped laser beam in a third direction of the body part to have a co-focus by the laser filter part.

2. The dual laser optic module of a turntable-type probe pin laser bonding apparatus of claim 1,
wherein the first and second laser connection units are vertically or horizontally divided around the body unit so that the first and second laser beams having different wavelength bands are vertically incident into the body unit.

3. The dual laser optic module of a turntable-type probe pin laser bonding apparatus of claim 2,
wherein the laser filter unit is installed to be inclined toward the first and second laser connection units inside the body unit.

4. The dual laser optic module of a turntable-type probe pin laser bonding apparatus of claim 1,
wherein the first and second laser connection units each have a collimation lens therein, and any one of the first and second laser connection units is further equipped with a diffractive optical element (DOE) lens therein.

5. The dual laser optic module of a turntable-type probe pin laser bonding apparatus of claim 1,
wherein the overlapping laser emitting unit is equipped with a focusing lens therein.

6. The dual laser optic module of a turntable-type probe pin laser bonding apparatus of claim 1,
wherein the first and second laser beams emitted from the overlapping laser emitting unit have different wavelengths and different areas.

7. The dual laser optic module of a turntable-type probe pin laser bonding apparatus of claim 1,
wherein the wavelengths of the first and second laser beams are 980nm and 808nm, respectively.
